(19) Europäisches Patentamt
European Patent Office
Office européen des brevets

(11) **EP 4 752 634 A2**

(12) **EUROPEAN PATENT APPLICATION**

(43) Date of publication:
**03.06.2026 Bulletin 2026/23**

(51) International Patent Classification (IPC):
***G03F 7/00*** *(2006.01)*

(21) Application number: **26174300.9**

(22) Date of filing: **23.04.2026**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(71) Applicant: **ASML Netherlands B.V.**
**5500 AH Veldhoven (NL)**

(72) Inventors:
• **PEREZ REY, Luis, Armando**
**5500 AH Veldhoven (NL)**
• **CIOPRAGA, Razvan**
**5500 AH Veldhoven (NL)**

• **KOK, Gijs**
**5500 AH Veldhoven (NL)**
• **SUN, Wei**
**5500 AH Veldhoven (NL)**
• **LEMMERS, Dorus**
**5500 AH Veldhoven (NL)**
• **DER SARKISSIAN, Henri, Haroutune**
**5500 AH Veldhoven (NL)**
• **LOEPPRICH, Omar, Edmond**
**5500 AH Veldhoven (NL)**
• **ISOLA, Alfonso, Agatino**
**5500 AH Veldhoven (NL)**

(74) Representative: **ASML Netherlands B.V.**
**Corporate Intellectual Property**
**P.O. Box 324**
**5500 AH Veldhoven (NL)**

(54) **A METROLOGY METHOD AND ASSOCIATED METROLOGY APPARATUS**

(57) Disclosed is a method of correcting a metrology image. The method comprises obtaining a degraded metrology image of a structure on a substrate, having been degraded due to motion-induced effects resulting from the motion of a substrate support system; obtaining a substrate stage trajectory prediction model and an image correction model; using the substrate support system trajectory prediction model to predict at least one substrate support system trajectory responsible for the degradation of the degraded metrology image; and using the image correction model to predict a corrected metrology image from the degraded metrology image and the predicted substrate support system trajectory.

Fig. 6

**Description**

FIELD OF THE INVENTION

The present invention relates to a metrology method such as may be performed for monitoring a lithographic process.

BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, a measure of the accuracy of alignment of two layers in a device. Overlay may be described in terms of the degree of misalignment between the two layers, for example reference to a measured overlay of 1 nm may describe a situation where two layers are misaligned by 1 nm.

Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target by iterative approaches such as rigorous coupled wave analysis or finite element methods; library searches; and principal component analysis.

The targets used by conventional scatterometers are relatively large, e.g., gratings of $40\mu m$ by $40\mu m$ and the measurement beam generates a spot that is smaller than the grating (i.e., the grating is underfilled). This simplifies mathematical reconstruction of the target as it can be regarded as infinite. However, in order to reduce the size of the targets, e.g., to $10\mu m$ by $10\mu m$ or less, e.g., so they can be positioned in amongst product features, rather than in the scribe lane, metrology has been proposed in which the grating is made smaller than the measurement spot (i.e., the grating is overfilled). Typically such targets are measured using dark-field scatterometry in which the zeroth order of diffraction (corresponding to a specular reflection) is blocked, and only higher orders processed. Examples of dark-field metrology can be found in international patent applications WO 2009/078708 and WO 2009/106279 which documents are hereby incorporated by reference in their entirety. Further developments of the technique have been described in patent publications US20110027704A, US20110043791A and US20120242970A. Modifications of the apparatus to improve throughput are described in US2010201963A1 and US2011102753A1. The contents of all these applications are also incorporated herein by reference. Diffraction-based overlay using dark-field detection of the diffraction orders enables overlay measurements on smaller metrology targets. These targets can be smaller than the illumination spot and may be surrounded by product structures on a wafer. Targets can comprise multiple gratings which can be measured in one image.

In the known metrology technique, measurement results are obtained by measuring a metrology target to obtain the -1 and the +1 diffraction order intensities. The intensity asymmetry, a comparison of these diffraction order intensities, in the metrology target can be used as an indicator of the parameter of interest (e.g., overlay, dose or focus), where overlay describes an undesired misalignment of two layers, and focus and dose describe the focus and dose of the exposure when exposing the metrology target.

The acquired metrology images using techniques such as described above may be subject to a motion induced blurring caused by motion of the substrate support system used to hold and move the substrate during metrology.

It would be desirable to be able to process metrology images to reduce the effect of motion induced blurring.

SUMMARY OF THE INVENTION

The invention in a first aspect provides a method of correcting a metrology image, comprising: obtaining a degraded metrology image of a structure on a substrate, having been degraded due to motion-induced effects resulting from the motion of a substrate support system supporting the substrate during and/or immediately prior to acquisition of the metrology image; obtaining a substrate support system trajectory prediction model and an image correction model; using the substrate support system trajectory prediction model to predict at least one substrate support system trajectory responsible for the degradation of the degraded metrology image; and using the image correction model to predict a corrected metrology image from the degraded metrology image and the predicted substrate support system trajectory.

The invention in a second aspect provides a method of training an image correction model to correct a degraded metrology image of a structure on a substrate, having been degraded due to motion-induced effects resulting from the motion of a substrate support system supporting the substrate during and/or immediately prior to acquisition of the metrology image, the method comprising: obtaining a training dataset comprising a plurality of training degraded metrology images and a plurality of training reference metrology images of the same one or more structures; performing a first training step to train at least a substrate support system trajectory prediction model to predict substrate support system trajectories for each of the training degraded metrology images; and performing a second training step comprising: using the trained substrate support system trajectory prediction model to predict substrate support system trajectories for each of the training degraded metrology images, and using the predicted substrate support system trajectories to train the image correction model to correct the training degraded metrology images based on the training reference metrology images.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

## BRIEF DESCRIPTION OF THE DRAWINGS

Embodiments of the invention will now be described, by way of example only, with reference to the accompanying drawings in which:

Figure 1 depicts a lithographic apparatus according to an embodiment of the invention;
Figure 2 depicts a lithographic cell or cluster according to an embodiment of the invention;
Figure 3 comprises (a) a schematic diagram of an inspection apparatus according to a first embodiment of the invention, (b) representation of a substrate W and target T in a first orientation, (c) representation of the substrate W and target T in a second orientation, (d) schematic illustration of the capture of a +1 diffraction order with a substrate in the first orientation (e) and schematic illustration of capture of a -1 diffraction order with the substrate in the second orientation;
Figure 4 depicts a known form of a multiple grating target and an outline of a measurement spot on a substrate;
Figure 5 depicts an image of the target of Figure 4 obtained in the inspection apparatus of Figure 3(a);
Figure 6 comprises a flow and model component diagram illustrating the components and training of an image correction model according to concepts disclosed herein;
Figure 7 comprises a flow and model component diagram illustrating the components and training of a stage trajectory prediction model according to concepts disclosed herein;
Figure 8 comprises a flow and model component diagram illustrating the components and training of an image correction model according to concepts disclosed herein; and
Figure 9 comprises a flow and model component diagram illustrating the components and use of an image correction model according to concepts disclosed herein.

## DETAILED DESCRIPTION OF EXEMPLARY EMBODIMENTS

Before describing embodiments of the invention in detail, it is instructive to present an example environment in which embodiments of the present invention may be implemented.

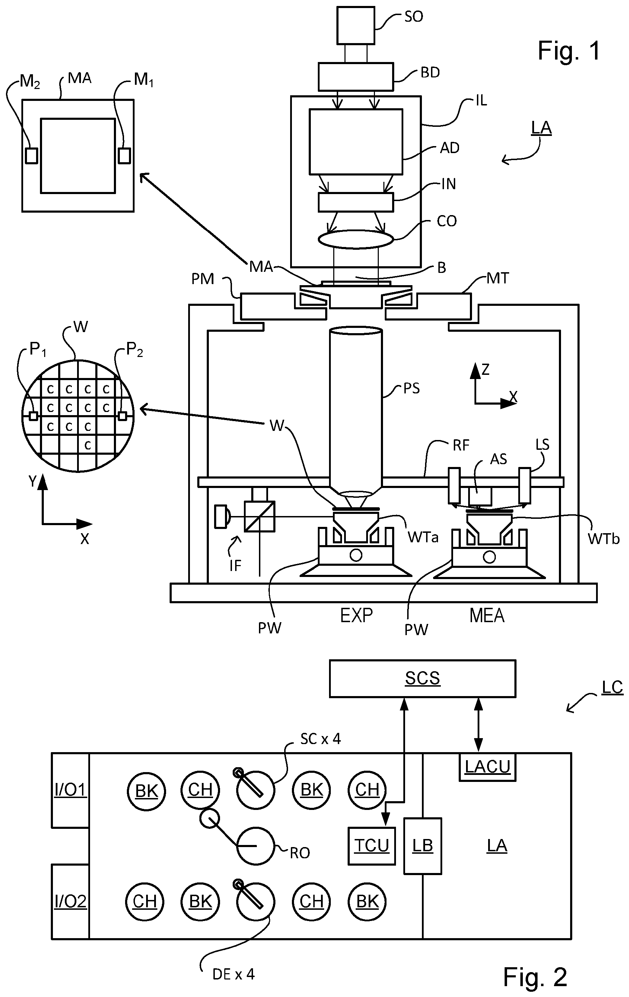

Figure 1 schematically depicts a lithographic apparatus LA. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; a substrate table (e.g., a wafer table) WTa, WTb constructed to hold a substrate (e.g., a resist coated wafer) W and connected to a second positioner PW configured to accurately position the substrate in accordance with certain parameters; and a projection optical system (e.g., a refractive projection lens system) PS configured to project a pattern imparted to the radiation beam B by patterning device MA onto a target portion C (e.g., including one or more dies) of the substrate W. In addition, the lithographic apparatus includes a reference frame RF.

The illumination optical system may include various types of optical or non-optical components, such as refractive, reflective, magnetic, electromagnetic, electrostatic or other types of components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table MT), and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WTa, WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment markers may also be included within dies, in amongst the device features, in which case it is desirable that the markers be as small as possible and not require any different imaging or process conditions than adjacent features.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS and measuring the position of alignment markers on the substrate using an alignment sensor AS. This enables a substantial increase in the throughput of the apparatus.

The depicted apparatus can be used in a variety of modes, including for example a step mode or a scan mode. The construction and operation of lithographic apparatus is well known to those skilled in the art and need not be described further for an understanding of the present invention.

As shown in Figure 2, the lithographic apparatus LA forms part of a lithographic system, referred to as a lithographic cell LC or a lithocell or cluster. The lithographic cell LC may also include apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET (not shown) which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Within metrology system MET, an inspection (or metrology) apparatus is used to determine the properties of the substrates, and in particular, how the properties of different substrates or different layers of the same substrate vary from layer to layer. The inspection apparatus (not shown) may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatuses have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

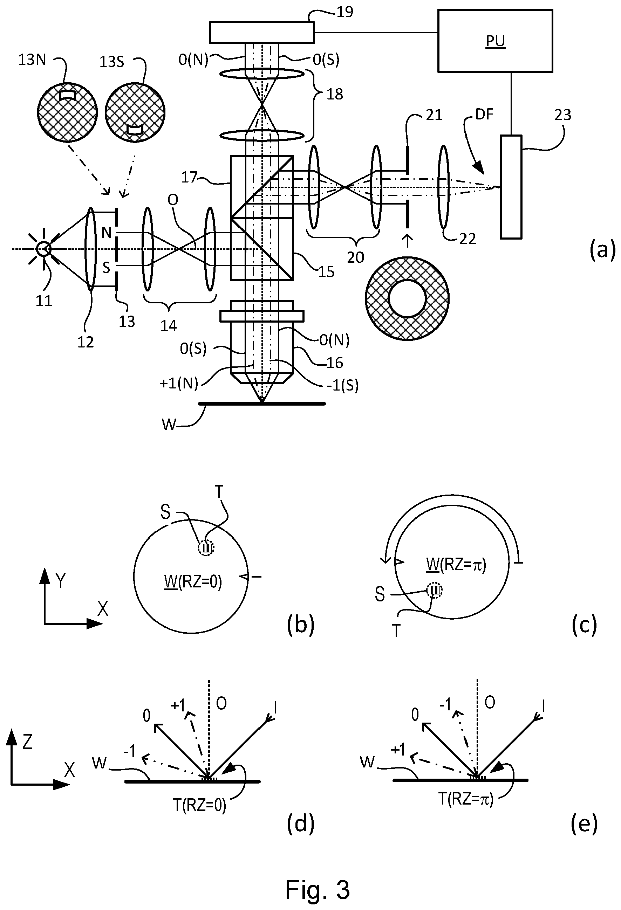

A metrology apparatus is shown in Figure 3(a). A target T and diffracted rays of measurement radiation used to illuminate the target are illustrated in more detail in Figures 3(b), 3(c), 3(d), 3(e). The metrology apparatus illustrated is of a type known as a dark-field metrology apparatus. The metrology apparatus depicted here is purely exemplary, to provide an explanation of dark-field metrology. The metrology apparatus may be a stand-alone device or incorporated in either the lithographic apparatus LA, e.g., at the measurement station, or the lithographic cell LC (as shown in Fig. 2). An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

In Figure 3(b), we see an example target T on a substrate W brought into measurement field S in a first orientation, which we can define by a rotation angle RZ of zero degrees (RZ=0). In Figure 3(c) we see the same target T brought into measurement field S with a rotation of 180 degrees (RZ=$\pi$ in radians). It will be understood that the sizes of measurement field and target here are greatly exaggerated for the sake of illustration. A real substrate may have many targets distributed across it, for measuring overlay and other parameters at different positions on the substrate. The diameter of measurement field S may be for example between 10 and 50 $\mu$m, while the target T fits within the measurement field diameter in this type of small target metrology. The target is thus referred to as "overfilled".

Figures 3 (d) and 3(e) show schematically more detail of the diffraction spectrum that results when a periodic structure (grating) of target T is placed into measurement field S with substrate W normal to the optical axis O of objective lens 16, for the measurement examples of Figure 3(b) and 3(c) respectively. In Figure 3(d) the orientation RZ=0 is used, while in Figure 3(e) the 180 degree rotated orientation is used (RZ=$\pi$). In each case, target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). The two first order rays are reversed for each of the two wafer rotations. It should be remembered that with an overfilled small target, these rays are just one of many parallel rays covering the area of the substrate including metrology target T and other features. Since the aperture in plate 13 has a finite width (necessary to admit a useful quantity of light), the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 3(a), 3(d) and 3(e) are shown somewhat off axis, purely to enable them to be more easily distinguished in the diagram.

At least the 0 and +1/-1 orders diffracted by the target T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target T on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented.

As such, the particular forms of aperture plate 13 and field stop 21 shown in Figure 3(a) are purely examples. In another embodiment of the invention, on-axis illumination of the targets is used and an aperture stop with an off-axis aperture is used to pass substantially only one first order of diffracted light to the sensor. In other examples, a two quadrant aperture may be used. This may enable simultaneous detection of plus and minus orders, as described in US2010201963A1, mentioned above. Embodiments with optical wedges (segmented prisms or other suitable elements) in the detection branch can be used to separate the orders for imaging spatially in a single image, as described in US2011102753AI, mentioned above. In yet other embodiments, 2nd, 3rd and higher order beams (not shown in Figure 3) can be used in measurements, instead of or in addition to the first order beams. In yet other embodiments, a segmented prism can be used in place of aperture stop 21, enabling both +1 and -1 orders to be captured simultaneously at spatially separate locations on image sensor 23.

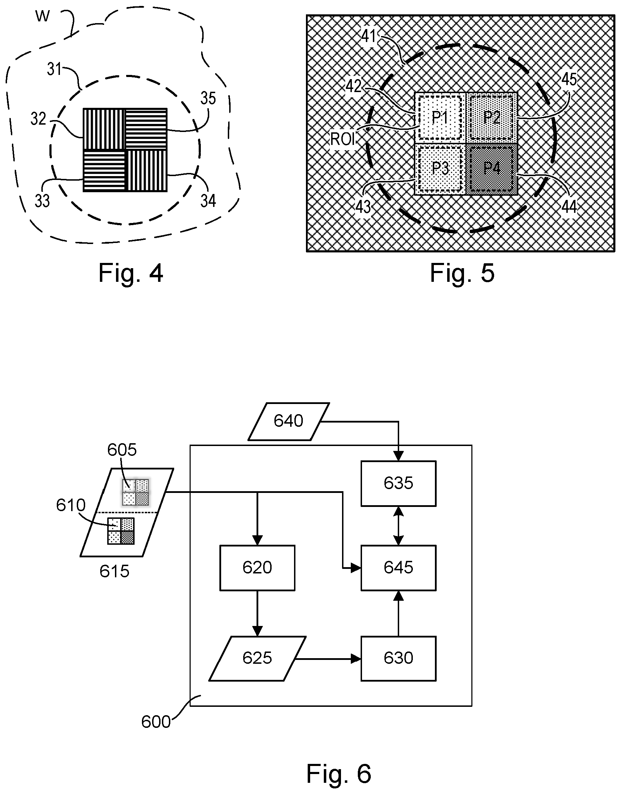

Figure 4 depicts an overlay target or composite overlay target formed on a substrate according to known practice. The overlay target in this example comprises four sub-targets (e.g., gratings) 32 to 35 positioned closely together so that they will all be within a measurement spot 31 formed by the illumination beam of the metrology apparatus. Overlay targets and sub-targets are examples of structures formed on a substrate. The four sub-targets thus are all simultaneously illuminated and simultaneously imaged on sensor 23. In an example dedicated to measurement of overlay, sub-targets 32 to 35 are themselves composite structures formed by overlying gratings that are patterned in different layers of the semiconductor device formed on substrate W. Sub-targets 32 to 35 may have differently biased overlay offsets in order to facilitate measurement of overlay between the layers in which the different parts of the composite sub-targets are formed. Sub-targets 32 to 35 may also differ in their orientation, as shown, so as to diffract incoming radiation in X and Y directions. In one example, sub-targets 32 and 34 are X-direction sub-targets with biases of the +d, -d, respectively. Sub-targets 33 and 35 are Y-direction sub-targets with offsets +d and -d respectively. Separate images of these sub-targets can be identified in the image captured by sensor 23. This is only one example of an overlay target. An overlay target may comprise more or fewer than 4 sub-targets.

Figure 5 shows an example of an image that may be formed on and detected by the sensor 23, using the overlay target of Figure 4 in the apparatus of Figure 3. While the pupil plane image sensor 19 cannot resolve the different individual sub-targets 32 to 35, the image sensor 23 can do so. The hatched area 40 represents the field of the image on the sensor, within which the illuminated spot 31 on the substrate is imaged into a corresponding circular area 41. Within this, rectangular areas 42-45 represent the images of the small overlay target sub-targets 32 to 35. If the overlay targets are located in product areas, product features may also be visible in the periphery of this image field. Image processor and controller PU processes these images using pattern recognition to identify the separate images 42 to 45 of sub-targets 32 to 35. In this way, the images do not have to be aligned very precisely at a specific location within the sensor frame, which greatly improves throughput of the measuring apparatus as a whole.

Once the separate images of the overlay sub-targets have been identified, the intensities of those individual images can be measured, e.g., by averaging or summing selected pixel intensity values within the identified areas, often referred as a region of interest (ROI). Intensities and/or other properties of the images can be compared with one another. These results can be combined to measure different parameters of the lithographic process. Overlay performance is an important example of such a parameter.

Using for example the method described in applications such as US20110027704A, mentioned above, overlay error (i.e., undesired and unintentional overlay misalignment) between the two layers within the sub-targets 32 to 35 is measured. Such a method may be referred to as micro diffraction based overlay ($\mu$DBO). This measurement may be done through overlay target asymmetry, as revealed by comparing their intensities in the +1 order and -1 order dark-field images (the intensities of other corresponding higher orders can be compared, e.g. +2 and -2 orders) to obtain a measure of the intensity asymmetry.

In a known method using a multi-grating target (with gratings of pitch p) such as the target illustrated in Figure 4, the overlay OV can be determined, for example, using the following equation:

$$OV = \frac{p}{2\pi}\tan^{-1}\left(\tan\left(\frac{2\pi d}{p}\right)\left(\frac{\left(I_{+d}^{+1} - I_{+d}^{-1}\right) + \left(I_{-d}^{+1} - I_{-d}^{-1}\right)}{\left(I_{+d}^{+1} - I_{+d}^{-1}\right) - \left(I_{-d}^{+1} - I_{-d}^{-1}\right)}\right)\right)$$

$$\cong d\frac{A_{+d} + A_{-d}}{A_{+d} - A_{-d}}$$

where:

- $I_{+d}^{+1}$ is the +1st diffraction order from positive bias target (e.g., intensity value);

- $I_{+d}^{-1}$ is the -1st diffraction order from positive bias target;

- $I_{-d}^{+1}$ is the +1st diffraction order from negative bias target;

- $I_{-d}^{-1}$ is the -1st diffraction order from negative bias target;

- $A_{+d} = I_{+d}^{+1} - I_{+d}^{-1}$ ; (e.g., asymmetry in the +1st and -1st intensities from positive bias target); and

- $A_{-d} = I_{-d}^{+1} - I_{-d}^{-1}$ , (e.g., asymmetry in the +1st and -1st intensities from negative bias target).

To successfully perform diffraction based metrology, such as μDBO or diffraction based focus (DBF), the obtained images of each target should ideally be sharp. Most optical metrology systems use a substrate support system (e.g substrate stage) to carry, support and/or hold as well as move the substrate, so as to be able to illuminate individual targets on the substrate. A substrate stage is prone to errors: it has a system-inherent settling time before coming to a complete standstill, and it also dissipates energy via the frame of the metrology tool itself, causing vibrations in the optical system of the metrology tool. An alternative substrate support system may comprise a clamping mechanism that may be actuated to both hold and move the substrate around. Other examples of substrate support systems prone to errors in expected position due to their motion may be conceivable by the person skilled in the art. All these errors can lead to motion-induced degradation in the acquired images due to transitory movement of the support system and/or optical system of the metrology tool. This motion-induced degradation may manifest as image blur. Images with degradation, when processed by parameter of interest (e.g., overlay or focus) inference algorithms such as have been described, can produce different parameter of interest values compared to the images of the same target without any degradation. This discrepancy represents an error in the parameter of interest inference. Furthermore, images with degradation can produce different metrology performance parameter values (e.g dynamic precision across repeated measurements, overlay accuracy, focus accuracy) compared to the images of the same target without any degradation.

When the substrate support system of a metrology system is set to operate at faster velocities and/or accelerations, the likelihood of image degradation is higher. To mitigate this and decrease image deterioration, presently the substrate support system is operated at a reduced speed (i.e., significantly below its maximum operational speed).

The obvious solution to these problems would be to upgrade the hardware components within the metrology system to improve image quality. For example, the metrology frame of the metrology system may be improved to reduce vibrations during movement and image acquisition. However, such solutions are too costly to be practical in real terms. The system is thus limited by the present hardware.

One of the main problems of improving image quality is that it is an ill-posed problem: an image can be "improved" in multiple ways. Therefore, the solution space of potential image restoration models that may be used to correct the images (e.g., a training set of the images) is quite large.

To solve the problem of finding a suitable image correction model, it is possible to constrain the problem by limiting the solution space of potential image correction models. For example, in the case of improving the quality of an image of a μDBO target that has been blurred due to vibrations caused by the high speed of the substrate support system, it has been observed that using existing deblurring algorithms on blurred images of μDBO targets improves the visual quality of the images. However, the overlay estimates do not agree with equivalent estimates for the same targets without blur, i.e., from images acquired at slow substrate support system speed settings. This is because typical image reconstruction or correction methods only use correction losses that favor visual cosmetic reconstructions, resulting in models that are not optimized for matching overlay predictions.

To address the issues described, an image correction method is proposed which trains an image correction model (or image reconstruction model) $M : \mathbb{R}^{W \times H} \to \mathbb{R}^{W \times H}$ to reduce parameter of interest mismatch (i.e., to reduce the difference in an inferred value for the parameter of interest) between parameter of interest values inferred from corrected degraded images (i.e., subsequent to correction by the model) and parameter of interest values inferred from reference images. The degraded images (referred to as fast images) may comprise images acquired at fast substrate support system speeds $x_{n,fast} \in : \mathbb{R}^{W \times H}, x_{c,fast} \in : \mathbb{R}^{W \times H}$ with width W and height $H$ and the reference images (referred to as slow images) may comprise images acquired at a slow wafer support system speed $x_{n,slow} \in : \mathbb{R}^{W \times H}, x_{c,slow} \in : \mathbb{R}^{W \times H}$. In each case, the subscript $n, c$ indicates the normal image (conventionally the image of the +1 diffraction order from the target) and complementary (conventionally the image of the -1 diffraction order from the target) respectively, in addition to the self-explanatory *fast, slow* to indicate images obtained at the fast and slow substrate support system settings respectively. The model may be trained on a training dataset of images of the same targets acquired at both slow and fast substrate support system speeds.

Parameter of interest mismatch is only one example of prior information which may be used to constrain training of the image correction model. Another prior may comprise motion trajectory priors based on some expected known behavior of the movement. These priors may be further used to constrain the initial training of a motion trajectory prediction model and/or degradation model as will be described. Such priors may relate to one or more of the maximum frequencies of movement, the size of movement, the area of effect of the movement, and/or smoothness of the trajectories.

A small variation prior may minimize or constrain variation within each region of interest of each sub-target, as each region of interest is expected to comprise a substantially constant intensity with little pixel variation. This prior may be enforced using a denoising model as will be described.

The description below will consider the specific use case of overlay metrology, and more specifically μDBO overlay metrology (i.e optical metrology). However, the methods are not so limited and can be used for any metrology method (also non-optical) which may be subject to image degradation due to vibrations caused by movement of the substrate support system, e.g., substrate stage at high speed.

Figure 6 illustrates the components and training of an image correction model 600 according to an embodiment of the invention. A training dataset 615 comprises degraded fast images 605 (i.e training degraded metrology images) and corresponding (i.e., of the same targets) undegraded (or less degraded) slow images 610 (i.e training reference metrology images). The image correction model 600 comprises a motion trajectory prediction model 620 which in use provides a motion trajectory prediction 625. Based on the motion trajectory prediction 625, a degradation model 630 predicts the image degradation caused by the predicted substrate stage motion 625. The degradation model 630 is a non-trainable block which combines the predicted motion trajectory 625 with a forward operator (blur operator), which operates on a sharp image to yield a blurred image, and an adjoint of the forward operator, which operates on the blurred image to yield gradients (i.e., not a sharp image). More specifically, the forward operator applies blur by following the predicted trajectory 625 and computing a corresponding blur kernel, which it then applies to the image. The motion trajectory prediction model 620 may be trained in an initial, first, (pre-)training step on the training dataset 615 and fixed. Training of the motion trajectory prediction model 620 in the first training step is done jointly with the degradation model 630 as will be described later.

In a second, main training step following the initial, first, training step, the image correction model 600 is trained e.g., by training the degradation model inverter 645 to iteratively reconstruct the sharp, undegraded slow images 610 from the degraded fast images 605. For this, the fixed motion trajectory prediction model 620 and degradation model 630 are used to make degradation predictions on the training data 615 (i.e., on the degraded fast images 605 comprised therein).. The training of the degradation model inverter 645 may be such that, in addition to maintaining fidelity between the slow and fast images, the training also prefers results for which a difference between respective inferred parameter of interest values from each of the slow and fast images is minimized. This last feature ensures that only cosmetic "corrections" are rejected should they result in large parameter of interest inference variation.

The second, main training step may also use a denoising model 635 (e.g., a neural network) which may be injected with random (e.g., Gaussian) noise 640 and trained to correct the acquired images (e.g., the reference/slow images) for this noise. The denoising model 635 may prevent drift from plausible solution space during iterative training of the degradation model inverter 645. The denoising model 635 may be pretrained and fixed for each iteration of the training of the degradation model inverter 645. The reference images can then be denoised using the trained denoising model 635 such that denoised reference images are used for each iteration of the main model (i.e., the degradation model inverter 645) training.

The motion trajectory prediction model 620 predicts the (e.g., most plausible) substrate support system trajectory which would have produced the fast images $x_{fast}$ from the slow images $x_{slow}$. As previously described, this motion trajectory prediction model may be pre-trained and fixed in an initial training step prior to training of the full image correction model in a second step. The (pre-) training of the motion trajectory prediction model therefore may use the same training dataset (or a different dataset) as used for training the full model, where the training dataset may comprise images of targets acquired at the slow and fast substrate support system setting (i.e the training degraded and training reference images, respectively). Given that multiple trajectories can result in the same fast images, the properties of the predicted trajectories can also be constrained based on some expected and/or known behavior of the movement. For example, such regulation may be based on one or more of *inter alia,* the maximum frequencies of movement, the size of movement, the area of effect of the movement, and smoothness of the trajectories. Specific examples will be described below. Although the motion trajectory prediction model 620, degradation model 630 and denoising model 635 are illustrated in Fig. 6 as integral parts or components models of the image correction model 600, these models may as well in other embodiments of the invention be implemented as separate models and used separately of the image correction model 600 comprising the degradation model inverter 645, to which an input degraded image may be fed.

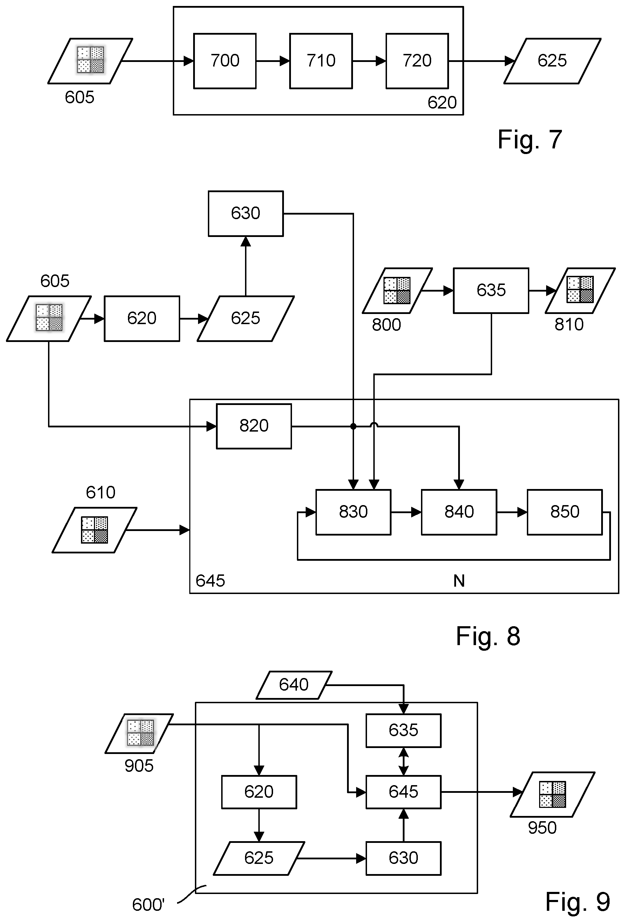

Figure 7 illustrates the components of a motion trajectory prediction model 620 which predicts a substrate support system motion trajectory 625 responsible for degradation of a degraded image 605, according to an embodiment of the invention. The motion trajectory prediction model 620 comprises an encoder component 700, which provides an efficiently encoded representation of the degraded image 605. Such an encoder component may comprise one or more Global Additive Multidimensional Averaging (GAMA) blocks, which are described in Mansour, Youssef, and Reinhard Heckel. *"GAMA-IR: Global Additive Multidimensional Averaging for Fast Image Restoration"* arXiv preprint arXiv:2404.00807 (2024), which is incorporated herein by reference. However other encoder architectures may be used.

Briefly, each GAMA block is a neural network having been trained to globally average a feature of size $C \times H \times W$ across each dimension separately, resulting in three feature maps of sizes $1 \times H \times W$, $C \times 1 \times W$, and $C \times H \times 1$. The latter two are transposed to $1 \times C \times W$ and $1 \times H \times C$ respectively. The three feature maps are convolved with three separate 2D convolutions (e.g., with input and output channels = 1, and kernel size = 7). Finally, the resulting feature maps are transposed and then expanded to match the initial input size ($C \times H \times W$) before being added together with the input feature map to generate the block's output.

The output of the encoder component 700 is used as in input for a global motion projection component 710. This may comprise a further GAMA block and a projection block. The projection block maps the output of the GAMA block to a 2D or 3D motion space to create the control points for the proposed trajectory. The interpolation block 720 then creates intermediate points between those control points to create a curve. The number of points of interpolation can be selected as an input. The projection and interpolation blocks are not based on neural networks.

More specifically, the projection block has the role of compressing the rich representation generated by the encoder component 700 into a time series of points which describe the global motion trajectory of the target. These points may be 2D (x,y) when only motion within the image plane is considered or 3D (x,y,z) when motion or vibrations perpendicular to the image plane are considered. In the example implementation, the projection block is a series of linear layers and activations, with a final activation free linear layer at the end. Finally, the interpolation block 720 maps the projection block 710 output to the trajectory 625. The interpolation block up-samples the output of the projection block into a denser trajectory. This block does not contain trainable parameters; it is simply a cubic spline interpolation block. It also centers the final trajectory in order to ensure that applying the interpolation will not shift the target within the image plane (i.e., so that the target gets smeared, but does not get moved from the center of the image).

Next, the training of the motion trajectory prediction model 620 in an embodiment will be described. The training dataset may comprise true degraded images (real images) instead of using artificially generated ones (i.e., the training does not average sharp frames or use synthetic blur kernels).

Consider a motion trajectory neural network $MT: \mathbb{R}^{W \times H} \to \mathbb{R}^{T \times S \times W \times H}$ estimator which takes an input image $x \in \mathbb{R}^{W \times H}$ and estimates for each pixel of the image a movement trajectory in the S-dimensional motion space discretized by $T$ points. When the motion space's dimensionality is chosen as S=2, the trajectory is represented by 2D points (x,y) corresponding to in-plane image motion. When the motion space has dimensionality S=3, the trajectory is represented by 3D points (x,y,z), which can further capture motion or vibrations perpendicular to the image plane. Such three-dimensional modeling may increase the expressive capacity of the model and result in an improved image correction performance. However, this benefit may come at the expense of an increased computational cost and model complexity. The trajectory prediction is done for the whole image, either as a whole or subdivided. In the subdivided case, the image is divided into region of pixels and each region gets its prediction or in an extreme case each pixel gets its prediction. Adding a prediction per region would increase the expressivity of the damaging process that is modelled i.e. more complex blur mechanisms, at the expense of computational complexity and model complexity. As previously described, the motion trajectory prediction model is trained jointly with the degradation model. The outputs of the motion trajectory are used by the degradation model $D: \mathbb{R}^{T \times S \times W \times H} \times \mathbb{R}^{W \times H} \to \mathbb{R}^{W \times H}$, which comprises a forward operator and its mathematical adjoint, to reproduce the degradation caused by the substrate support system movement, taking into account the predicted motion. The motion trajectory prediction model 620 may be trained with the following loss weighted by the hyperparameter weights $\lambda_1, \lambda_2, \lambda_3, \lambda_4$:

$$\lambda_1 Reg_1\left(MT\left(x_{fast}\right)\right) + \lambda_2 Reg_2\left(MT\left(x_{fast}\right)\right) + \lambda_3 MSE(|D\left(MT\left(x_{fast}\right), x_{slow}\right) - x_{fast}|^2$$

$$+ \lambda_4 SSIM(D\left(MT\left(x_{fast}\right), x_{slow}\right), x_{fast})$$

The first and second terms are motion prediction regularization terms which relate to the motion trajectory prediction model 620 and the third and fourth terms relate to the degradation model 630. The regularization applied may comprise one or more of the four terms recited above, where each term provides a separate regularization function, namely:

- Magnitude regularization: The term $Reg_1$ ($MT(x)$) regularizes the magnitude of the trajectories to accommodate the expectation of small trajectories:

$$Reg_1\left(MT(x)\right) = \frac{1}{T} \sum_{t=1}^{T} MT_t^2(x)$$

where $MT_t$ is the t-th component of the motion trajectory curve predicted. This regularization forces the model to use the smallest or shortest possible trajectory to explain the degradation seen in the degraded image. This ensures the trajectory respects the properties of natural motions and prevents the model from creating sharp turns or very sparse points.

- Curvature regularization: The term $Reg_2$ ($MT(x)$) regularizes the curvature of the trajectory by minimizing the approximate second order derivative of the discretized curve along the trajectory parameterization first dimension:

$$Reg_2\big(MT(x)\big) = \frac{1}{T-2} \sum_{t=2}^{T-1} MT_{t+1}(x) - 2MT_t(x) + MT_{t-1}(x)$$

- Maximum frequency of movement prior: The maximum frequency of movement inferred is determined by the number of points $T$ used to predict the trajectory, the larger the number of points $T$, the higher the maximum movement frequencies that can be inferred. Using fewer time points reduces the possibility of inferring high frequency movements, so this can be used as an indirect way of regularizing the motion trajectory and force more regular, smooth and slowly changing motion patterns. Additionally, fewer points relaxes the problem, as the higher frequencies are significantly more ill-posed and harder to discern.
- Area of effect prior: The motion trajectory network can in principle predict one trajectory per pixel of the image. However, it is possible to restrict the uniformity of the expected movement across the image. The extreme case is when only one trajectory is predicted for the whole image $MT: \mathbb{R}^{W \times H} \to \mathbb{R}^{T \times S}$. Current evaluation showed that one trajectory is sufficient to attain good results.
- Degradation consistency terms: The third and fourth terms of the loss function calculate the mean squared error *MSE* and structural similarity index measure to ensure the degradation model output is consistent with the degraded images, by comparing the predicted degradation from the motion trajectory prediction model 620 and degradation model 630 to the degraded image 605 as acquired.

Once the motion trajectory prediction model 620 has been trained, it is fixed and its motion trajectory predictions are used during training of the full image correction model; i.e., this latter training (or second, main training step) is performed with the fixed motion trajectory prediction model 620.

Figure 8 illustrates the training of the image correction model 600, and in particular the degradation model inverter 645 component, in more detail, according to an embodiment of the invention. The image correction model is constructed by processing the degraded (fast) input images 605 through the pre-trained and fixed motion trajectory prediction model 620 and degradation model 630, to predict the most likely substrate support system trajectory responsible for the degraded image and the consequent image degradation. The degradation model inverter 645 iteratively reconstructs (over N iterations) a sharp reconstructed image using the predicted degradation from the inferred trajectories 625, while using the denoising model 635 to prevent drift from plausible solution space.

The degradation model inverter 645 comprises a hyperparameter estimator 820 which is trained to produce iteration-specific hyperparameters based on the input degraded image 605 in order to guide the optimization process (e.g., to weight prior vs data). It is this hyperparameter estimator 820 which is trained during the training of the degradation model inverter 645. A prior module which is a denoising module 830 applies a denoising step which enforces learned image priors (e.g., using the denoising model 635) while incorporating a gradient descent update using the gradients returned by the transpose of the forward operator of the degradation model 630. A data module 840 ensures that the current estimate is consistent with the observed degraded image 605, e.g., by solving a data fidelity sub-problem. The update module 850 updates the dual variable (e.g., Lagrange multiplier) to balance the prior and data terms.

The denoising module 830 may impose a small variation prior to fulfill predetermined intensity conditions. An expectation of μDBO (or other) target images is that they comprise individual regions of interest (per-sub-target) having low intensity variation. The denoising module may also enforce known intensity gradients for one or more of the sub-targets/regions of interest. The regions of interest of a (e.g., μDBO) targets vary in a certain, known manner when exposure conditions change. When the denoising model 635 is trained on image pairs (i.e., sharp, undegraded, or less degraded reference images and corresponding noisy or degraded images), it effectively learns how the targets usually look, since noising with Gaussian noise is equivalent to a "missing information" problem. During reconstruction, the denoising model 635 corrects small errors in solving of the reconstructions performed in each iteration of the reconstruction model, by enforcing this learned prior of how the targets should look.

To incorporate such expectations in the correction, a denoising neural network 635 $DM: \mathbb{R}^{W \times H} \to \mathbb{R}^{W \times H}$ is pretrained to remove Gaussian noise from the noisy images 800 to provide denoised images 810 (e.g., smoothened images). The model may be trained on the loss:

$$L_1\big(DM(x_{slow} + \epsilon), x_{slow}\big) + L_{Texture}\big(DM(x_{slow} + \epsilon), x_{slow}\big)$$

where $\varepsilon \sim \mathcal{N}(0, \sigma)$ is random Gaussian noise applied to each pixel, e.g., $\epsilon \in \mathbb{R}^{W \times H}$ with $\sigma \sim U(0, 0.05)$ used during training. This is only an example of applied noise; any other noise may be applied.

The (optional) second term $L_{Texture}$ is a texture loss term which further regularizes the spatial derivatives of the denoised image 810 and original image 800 so that they match. More specifically, for two images $x$ and $y$, the texture loss may be defined as $L_{texture}(x, y) = (\nabla x - \nabla y)^2$ with V the spatial derivative along the horizontal and vertical directions in the image plane.

The image correction model 600 is trained by using the pretrained motion trajectory model, degradation model and (per iteration) denoising model to optimize the following loss:

$$L_1\big(M(x_{n,fast}), x_{n,slow}\big) + L_1\big(M(x_{c,fast}), x_{c,slow}\big)$$
$$+ \lambda\, L_1\big(OV(x_{n,slow}, x_{c,slow}), OV(M(x_{n,fast})M(x_{c,fast}))\big)$$

with the first two terms corresponding to the fidelity terms that aim to ensure the model faithfully reproduces the slow substrate support system images and the last term, weighted by the hyperparameter $\lambda$, ensures the parameter of interest mismatch between corrected images $M(x_{n,fast})$, $M(x_{c,fast})$ and slow substrate support system images $x_{n,slow}$, $x_{c,slow}$ is minimized.

The function $L_1$ may be given by the squared error, optionally including a smoothing term, e.g., of an order of magnitude $\tau = 1e - 4$.

$$L_1(a, a') = \frac{1}{N}\sum_{n=1}^{N}\sqrt{(a_n - a'_n)^2 + \tau}$$

The function $OV(x_n, x_c)$ applied to a pair of normal $x_n$ and complementary $x_c$ μDBO images may comprise any suitable current overlay inference method used to estimate overlay from μDBO images. This function may be implemented in a differentiable manner, such that it is compatible with deep learning model training. Of course, other algorithms may be used for other diffraction based metrologies. Also, the $L_1$ "metrology" based loss is only a specific example implementation based on overlay inference, and other metrology performance indicators could be used instead; e.g., *inter alia:* a target statistical distribution metric such as a sigma metric (e.g., overlay 3-sigma), biased sub-target intensity asymmetries of a target, biased sub-target mean intensities of a target, a stack sensitivity metric.

Figure 9 illustrates a method of correcting a degraded (fast) image 905 to obtain a corrected image 950, using the trained image correction model 600'. The degraded image 905 is input to the trained image correction model 600'. The trained motion trajectory prediction model 620 determines a motion trajectory prediction 625. Based on the motion trajectory prediction 625, the degradation model 630 predicts the degradation caused by the substrate support system movement taking into account the predicted motion 625. The trained degradation model inverter 645 takes the output of the degradation model to remove the effect of the degradation, as predicted by the degradation model 930, from the degraded image 905, using the denoising model 635 to impose the small variation prior and maintain the solutions plausible. In other embodiments of the invention, the trained motion prediction model may not be used in combination with the degradation model 630 in image correction model 600 but instead may be used independently being a separate model to estimate a motion trajectory 625 from a degraded input image. In alternative embodiments, the degradation model itself is used as a separate model, receiving as input an image and a motion trajectory - retrieved by the motion trajectory prediction model 620 or obtained from measurements-and applying the forward operator to generate a corresponding degraded image. The outputs of the respective models may be fed to the degradation inverter 645 of the image correction model 600 to yield a corrected image.

Each of the model components 620, 630, 635, 645 of the image correction model 600 may comprise one or more neural networks.

While the normal image is described as the image of the +1 diffraction order from the target and the complementary image is described as the -1 diffraction order from the target, this does not need to be the case and any pair of complementary (opposite) diffraction orders may be used to infer the parameter of interest; e.g., the +2, -2 orders etc.

In the examples above, the normal and complementary images are processed together, as they have been captured together. Processing the normal and complementary images further constrains the solution space. However, this is not essential, and it is possible to separately process the normal images and complementary images using the methods described herein.

The methods disclosed herein may be applicable to other overlay target types and overlay methods. One such method may comprise continuous diffraction-based overlay (cDBO), which comprises measuring a target comprising sub-targets for which the gratings in each layer have different pitches. The order of the gratings are reversed in two complementary sub-targets (e.g., per direction); for example, a first-type sub-target may comprise the "M-type" sub-target which comprises the smaller pitch in the top layer and the second-type sub-target may comprise the "W-type" sub-target which comprises the larger pitch in the top layer.

The target arrangements illustrated and methods described have been those designed for measurement of overlay. However the concepts herein may also be applicable to target arrangements designed for measurement of another parameter of interest. For example, a focus arrangement (e.g., formed with regions having a focus sensitive asymmetry) can also benefit. Focus targets typically comprise features which have an asymmetry that has a (e.g., monotonic) relationship with scanner focus during their formation. This may be achieved, for example, by providing a grating or gratings with individual line features, where the line features each having sub-resolution features (assist features) along only one of its edges. These sub-resolution features cannot be exposed as they are too small, however their presence affects the formation of the edge of the line feature which depends on focus, thereby providing a focus dependent asymmetry. Therefore, by measuring intensity asymmetry from the target (e.g., in a similar manner to μDBO) the actual exposure focus during the target exposure can be inferred. Because of the similarity of the measurement strategy (intensity asymmetry, i.e., a comparison of the strength of +1 and -1 orders), and the fact that focus targets typically comprise two or more sub-targets (e.g., two sub-targets per measurement direction), the correction methods disclosed herein are equally applicable to DBF metrology

An embodiment may include a computer program containing one or more sequences of machine-readable instructions describing methods of measuring targets on a substrate and/or analyzing measurements to obtain information about a lithographic process in accordance with the concepts disclosed herein. This computer program may be executed for example within unit PU in the apparatus of Figure 3(a) and/or the control unit LACU of Figure 2. There may also be provided a data storage medium (e.g., semiconductor memory, magnetic or optical disk) having such a computer program stored therein. Where an existing metrology apparatus, for example of the type shown in Figure 3(a), is already in production and/or in use, the invention can be implemented by the provision of updated computer program products for causing a processor to perform the steps necessary to calculate the overlay error.

The program may optionally be arranged to control the optical system, substrate support and the like to perform the steps necessary to calculate the overlay error for measurement of asymmetry on a suitable plurality of targets.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), A well A particle beams, such A ion beams or electron beams.

The term "lens", where the context allows, may refer to any one or combination of various types of components, including refractive, reflective, magnetic, electromagnetic and electrostatic components.

The following numbered clauses describe examples of the concepts disclosed herein:

1. A method of correcting a metrology image, comprising:

obtaining a degraded metrology image of a structure on a substrate, having been degraded due to motion-induced effects resulting from the motion of a substrate support system supporting the substrate during and/or immediately prior to acquisition of the metrology image;
obtaining a substrate stage trajectory prediction model and an image correction model;
using the substrate support system trajectory prediction model to predict at least one substrate support system trajectory responsible for the degradation of the degraded metrology image; and
using the image correction model to predict a corrected metrology image from the degraded metrology image and the predicted substrate support system trajectory.

2. A method according to clause 1, wherein the substrate stage trajectory prediction model is one of: (i) a model implemented separately from the image correction model; or
(ii) a component model integrated within the image correction model.

3. A method according to any preceding clause, wherein the image correction model has been trained to minimize a difference between an inferred value of a parameter of interest or metrology performance parameter from the degraded metrology image and an inferred value of a parameter of interest or metrology performance parameter, respectively, from the corrected metrology image.

4. A method according to any preceding clause, wherein the image correction model has been trained simultaneously to:

maintain fidelity between the training degraded metrology images and the training corrected metrology images; and

minimize the difference between an inferred value of a parameter of interest from the training degraded metrology images and an inferred value of a parameter of interest from the training corrected metrology images.

5. A method according to any preceding clause, further comprising:

using a degradation model to predict image degradation resultant from the predicted substrate support system trajectory; and

wherein the step of using the image correction model to predict the corrected metrology image comprises using the image correction model to predict the corrected metrology image using the predicted image degradation.

6. A method according to clause 5, wherein the degradation model comprises a forward operator which operates to blur an image, and an adjoint of the forward operator, which operates on a blurred image to yield gradients.

7. A method according to any preceding clause, wherein the step of using the image correction model to predict a corrected metrology image uses a denoising model to impose a variation prior which favors solutions with predetermined intensity variation within one or more regions of interest of the corrected metrology image.

8.. A method according to any preceding clause, wherein the substrate support system trajectory prediction model has been trained to predict at least the shortest possible substrate support system trajectory responsible for the degradation of the degraded metrology image.

9. A method according to any preceding clause, wherein the step of using the substrate stage trajectory prediction model to predict at least one substrate stage trajectory comprises predicting a substrate stage trajectory for each of one or more points within the degraded metrology image.

10. A method according to any clause 9, wherein predicting a substrate stage trajectory for each of one or more points within the degraded metrology image comprises predicting at least one substrate stage trajectory for only a proper subset of the points within the degraded metrology image.

11. A method according to clause 9 or 10, wherein predicting at least one substrate stage trajectory for each of one or more points within the degraded metrology image comprises predicting only a single substrate stage trajectory for only a single point within the degraded metrology image.

12. A method according to any of clauses 9, 10 or 11, wherein the maximum frequency of movement of the at least one substrate stage trajectory is dependent upon the one or more points used to determine the at least one substrate stage trajectory.

13. A method according to any preceding clause, wherein the structure comprises at least a part of an overlay target or of a focus target.

14. A method according to any preceding clause, comprising using the corrected metrology image to determine a parameter of interest relating to the structure or a metrology performance parameter relating to a lithographic process.

15. A method according to any preceding clause, comprising initially training the image correction model using a training dataset, the training dataset comprising a plurality of training degraded metrology images and a plurality of training reference metrology images of the same one or more structures.

16. A method according to clause 15, wherein the training dataset comprises real metrology images, wherein the training degraded metrology images were obtained with the substrate stage moved at a higher speed between metrology image acquisitions than to obtain the training reference metrology images.

17. A method according to clause 15 or 16, wherein the training of the image correction model comprises:

training at least the substrate stage trajectory prediction model in a first training step;

fixing the trained substrate stage trajectory prediction model after the first training step; and

using the fixed, trained substrate stage trajectory prediction model to predict substrate stage trajectories for each of the training degraded metrology images during a second training step of training of the image correction model.

18. A method according to clause 17, wherein the second training step comprises training the image correction model to minimize a difference between inferred values of a parameter of interest or metrology performance parameter from the training degraded metrology images and inferred values of a parameter of interest or metrology performance parameter, respectively, from the training reference metrology images.

19. A method according to clause 17 or 18, wherein the second training step comprises training the image correction model simultaneously to:

maintain fidelity between the training degraded metrology images and the training reference metrology images; and

minimize the difference between the inferred values of a parameter of interest from the training degraded metrology images and the inferred values of a parameter of interest from the training reference metrology images.

20. A method according to any of clauses 17 to 19, wherein the second training step comprises optimizing a loss function comprising a fidelity term and a parameter of interest mismatch term.

21. A method according to clause 20, wherein the loss function comprises a hyperparameter for balancing the fidelity term with respect to the parameter of interest mismatch term.

22. A method according to any of clauses 18 to 21, wherein the first training step is regularized to constrain the substrate stage trajectory prediction model to predict the shortest possible trajectory which explains the degradation of the degraded metrology image.

23. A method according to any of clauses 18 to 22, wherein the substrate stage trajectory prediction model comprises a degradation model which predicts degradation based on a substrate stage trajectory prediction of the substrate stage trajectory prediction model, wherein the second training step uses the predicted image degradation of each of the training degraded metrology images to train the image correction model.

24. A method according to clause 23, comprising training the substrate stage trajectory prediction model to ensure that the degradation model output is consistent with the training degraded metrology images, by minimizing one or both of a mean squared error and structural similarity index of the degradation model output and the degraded metrology images.

25. A method according to clause 23 or 24, wherein the second training step comprises iteratively constructing the training reference metrology images from the training degraded metrology images using the predicted image degradation of each of the training degraded metrology images.

26. A method according to any of clauses 18 to 25, comprising training a denoising model for each iteration of the main training step; and
using the trained denoising model in each iteration to impose a small variation prior which favors solutions with small intensity variation within regions of interest of each training reference metrology images and/or to impose a prior which enforces expected intensity gradients within each region of interest.

27. A method according to clause 26, wherein the step of training the denoising model comprises training the denoising model to minimize a difference of the training reference metrology images and denoised noisy training reference metrology images, the denoised noisy training reference metrology images comprising the training reference metrology images with noise added and subsequently denoised by the denoising model.

28. A method according to clause 27, wherein the step of training the denoising model comprises training the denoising model to match spatial derivatives of the denoised noisy training reference metrology images and the training reference metrology images.

29. A method of training an image correction model to correct a degraded metrology image of a structure on a substrate, having been degraded due to motion-induced effects resulting from the motion of a substrate support system supporting the substrate during and/or immediately prior to acquisition of the metrology image, the method comprising:

obtaining a training dataset comprising a plurality of training degraded metrology images and a plurality of training reference metrology images of the same one or more structures;

performing a first training step to train at least a substrate support system trajectory prediction model to predict at least a substrate support system trajectory for each of the training degraded metrology images; performing a second training step comprising: using the trained substrate support system trajectory prediction model to predict substrate support system trajectories for each of the training degraded metrology images, and using the predicted substrate support system trajectories to train the image correction model to correct the training degraded metrology images based on the training reference metrology images.

30. A method according to clause 29, wherein the training dataset comprises real metrology images, wherein the training degraded metrology images were obtained with the substrate support system moved at a higher speed between metrology image acquisitions than to obtain the training reference metrology images.

31. A method according to clause 29 or 30, wherein the first training step comprises training the image correction model to minimize a difference between inferred values of a parameter of interest or metrology performance parameter from the training degraded metrology images and inferred values of a parameter of interest or metrology performance parameter, respectively, from the training reference metrology images.

32. A method according to any of clause 29 to 31, wherein the first training step comprises training the image correction model simultaneously to:

maintain fidelity between the training degraded metrology images and the training reference metrology images; and

minimize the difference between the inferred values of a parameter of interest from the training degraded metrology images and the inferred values of a parameter of interest from the training reference metrology images.

33. A method according to clause 32, wherein the second training step comprises optimizing a loss function comprising a fidelity term and a parameter of interest mismatch term.

34. A method according to clause 33, wherein the loss function comprises a hyperparameter for balancing the fidelity term with respect to the parameter of interest mismatch term.

35. A method according to any of clauses 29 to 34, wherein the first training step is regularized to constrain the substrate stage trajectory prediction model to predict the shortest possible trajectory which explains the degradation of the degraded metrology image.

36. A method according to any of clauses 29 to 35, wherein the substrate stage trajectory prediction model comprises a degradation model which predicts degradation based on a substrate stage trajectory prediction of the substrate stage trajectory prediction model, wherein the second training step uses the predicted image degradation of each of the training degraded metrology images to train the image correction model.

37. A method according to clause 36, comprising training the substrate stage trajectory prediction model to ensure that the degradation model output is consistent with the training degraded metrology images, by minimizing one or both of a mean squared error and structural similarity index of the degradation model output and the degraded metrology images.

38. A method according to clause 36 or 37, wherein the second training step comprises iteratively constructing the training reference metrology images from the training degraded metrology images using the predicted image degradation of each of the training degraded metrology images.

39. A method according to any of clauses 29 to 38, comprising training a denoising model for each iteration of the main training step; and

using the trained denoising model in each iteration to impose a small variation prior which favors solutions with small intensity variation within regions of interest of each training reference metrology images and/or to impose a prior which enforces expected intensity gradients within each region of interest.

40. A method according to clause 39, wherein the step of training the denoising model comprises training the denoising model to minimize a difference of the training reference metrology images and denoised noisy training reference metrology images, the denoised noisy training reference metrology images comprising the training reference metrology images with noise added and subsequently denoised by the denoising model.

41. A method according to clause 40, wherein the step of training the denoising model comprises training the denoising model to match spatial derivatives of the denoised noisy training reference metrology images and the training reference metrology images.

42. A computer program comprising computer readable instructions for implementing the method of any of clauses 1 to 41, when run on a suitable apparatus.

43. A computer program comprising computer readable instructions which implement a trained machine learning image correction model when run on a suitable apparatus, the trained image correction machine learning model having been trained using the training step of any of clauses 29 to 42.

44. A non-transient computer program carrier comprising the computer program of claim 42 and/or 43.

45. A processing apparatus comprising:

a processor; and
the non-transitory computer program carrier of clause 44.

46. A metrology apparatus comprising the processing apparatus of clause 45.

47. A metrology apparatus according to clause 46, comprising:

a substrate holder for holding a substrate;
projection optics for projecting illumination onto a substrate;
a detector for detecting said scattered radiation at a detection plane to obtain the degraded metrology image.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1.   A method of correcting a metrology image, comprising:

obtaining a degraded metrology image of a structure on a substrate, having been degraded due to motion-induced effects resulting from the motion of a substrate support system supporting the substrate during and/or immediately prior to acquisition of the metrology image;
obtaining a substrate stage trajectory prediction model and an image correction model;
using the substrate support system trajectory prediction model to predict at least one substrate support system trajectory responsible for the degradation of the degraded metrology image; and
using the image correction model to predict a corrected metrology image from the degraded metrology image and the predicted substrate support system trajectory.

2.   A method according to claim 1, wherein the substrate stage trajectory prediction model is one of: (i) a model implemented separately from the image correction model; or
(ii) a component model integrated within the image correction model.

3.   A method according to any preceding claim, wherein the image correction model has been trained to minimize a difference between an inferred value of a parameter of interest or metrology performance parameter from the degraded metrology image and an inferred value of a parameter of interest or metrology performance parameter, respectively, from the corrected metrology image.

4.   A method according to any preceding claim, further comprising:

using a degradation model to predict image degradation resultant from the predicted substrate support system trajectory; and
wherein the step of using the image correction model to predict the corrected metrology image comprises using the image correction model to predict the corrected metrology image using the predicted image degradation.

5.   A method according to any preceding claim, wherein the step of using the image correction model to predict a corrected metrology image uses a denoising model to impose a variation prior which favors solutions with predetermined intensity variation within one or more regions of interest of the corrected metrology image.

6.   A method according to any preceding claim, wherein the substrate support system trajectory prediction model has been trained to predict at least the shortest possible substrate support system trajectory responsible for the degradation of the degraded metrology image.

7.   A method according to any preceding claim, wherein the structure comprises at least a part of an overlay target or of a focus target.

8.   A method according to any preceding claim, comprising using the corrected metrology image to determine a parameter of interest relating to the structure or a metrology performance parameter relating to a lithography process.

9.   A method of training an image correction model to correct a degraded metrology image of a structure on a substrate, having been degraded due to motion-induced effects resulting from the motion of a substrate support system supporting the substrate during and/or immediately prior to acquisition of the metrology image, the method comprising:

obtaining a training dataset comprising a plurality of training degraded metrology images and a plurality of training reference metrology images of the same one or more structures;

performing an first training step to train at least a substrate support system trajectory prediction model to predict at least a substrate support system trajectory for each of the training degraded metrology images;

performing a second training step comprising: using the trained substrate support system trajectory prediction model to predict substrate support system trajectories for each of the training degraded metrology images, and using the predicted substrate support system trajectories to train the image correction model to correct the training degraded metrology images based on the training reference metrology images.

10. A method according to claim 9, wherein the training dataset comprises real metrology images, wherein the training degraded metrology images were obtained with the substrate support system moved at a higher speed between metrology image acquisitions than to obtain the training reference metrology images.

11. A method according to claim 9 or 10, wherein the second training step comprises training the image correction model to minimize a difference between inferred values of a parameter of interest or metrology performance parameter from the training degraded metrology images and inferred values of a parameter of interest or metrology performance parameter from the training reference metrology images.

12. A computer program comprising computer readable instructions for implementing the method of any of claims 1 to 11, when run on a suitable apparatus.

13. A non-transient computer program carrier comprising the computer program of claim 12.

14. A processing apparatus comprising:

a processor; and
the non-transitory computer program carrier of claim 13.

15. A metrology apparatus comprising the processing apparatus of claim 14.

Fig. 1

Fig. 2

Fig. 3

Fig. 4

Fig. 5

Fig. 6

Fig. 7

Fig. 8

Fig. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009078708 A
- WO 2009106279 A
- US 20110027704 A
- US 20110043791 A
- US 20120242970 A
- US 2010201963 A1
- US 2011102753 A1